# FASCICULE DE BREVET EUROPEEN

(11) **EP 3 772 746 B1**
(45) Date de publication et mention de la délivrance du brevet: **15.01.2025**
(21) Numéro de dépôt: 20189887.1
(22) Date de dépôt: 06.08.2020
(51) Int. Cl.: H01L 25/065, H01L 21/288, H01L 21/768, H01L 23/538, H01L 21/48

(54) **PROCÉDÉ DE FABRICATION DE VIAS TRAVERSANT UN SUBSTRAT**
VERFAHREN ZUR HERSTELLUNG VON DURCHGANGSVERBINDUNGEN DURCH EIN SUBSTRAT
METHOD FOR MANUFACTURING VIAS PASSING THROUGH A SUBSTRATE

(30) Priorité: 09.08.2019 FR 1909113
(43) Date de publication de la demande: 10.02.2021
(73) Titulaire: Commissariat à l'Energie Atomique et aux Energies Alternatives, 75015 Paris (FR)
(72) Inventeur: PARES, Gabriel, 38054 GRENOBLE CEDEX 9 (FR)
(74) Mandataire: Cabinet Beaumont

(56) Documents cités:
- WO-A1-2010/041165
- FR-A1- 2 930 840
- US-A1- 2015 235 899
- US-A1- 2017 287 728

## Description

### Domaine technique

La présente description concerne de façon générale les dispositifs électroniques, et plus particulièrement un dispositif comprenant un substrat traversé par des vias conducteurs de connexion entre des circuits électroniques.

### Technique antérieure

Une puce électronique de circuit intégré est définie par un substrat et par des éléments situés sur une face, dite face avant, du substrat. Parmi ces éléments, la puce comprend des circuits électroniques formés par des composants tels que des transistors, des résistances, des diodes, des condensateurs, etc., et par des liaisons électriquement conductrices entre ces composants. Une ou plusieurs puces électroniques peuvent être disposées dans un boîtier de circuit intégré. Un tel boîtier comprend typiquement des broches destinées à être connectées, par exemple soudées ou brasées, à un dispositif tel qu'un circuit imprimé de type PCB ("Printed Circuit Board").

Pour relier électriquement les circuits électroniques des puces entre eux et/ou à des structures conductrices tels que les broches du boîtier, on peut prévoir des connexions électriques par des vias conducteurs traversant le substrat des puces et/ou des vias conducteurs traversant un ou plusieurs substrats autres que ceux des puces.

Le document WO 2010/014465 décrit un procédé de revêtement de vias traversant une plaquette pour mise en boîtier tridimensionnel.

Le document US 2017/287728 décrit un procédé de métallisation de vias à l'intérieur d'un substrat.

Le document US 2015/235899 décrit un procédé de formation d'un fil traversant.

Le document FR 2 930 840 décrit un procédé de reprise de contact sur un circuit éclairé par la face arrière. Résumé de l'invention

Il existe un besoin de disposer d'un procédé de réalisation d'un substrat traversé de vias présentant, par rapport aux substrats usuels, un nombre plus élevé de vias par unité de surface.

Il existe un besoin de disposer d'un procédé de réalisation de vias plus simple à mettre en œuvre et/ou plus rapide que les procédés usuels.

Un mode de réalisation pallie tout ou partie des inconvénients des procédés connus de réalisation de vias.

Un mode de réalisation prévoit un procédé de fabrication selon la revendication 1.

Selon un mode de réalisation, les ouvertures ont un facteur de forme supérieur à 10.

Selon un mode de réalisation, une première couche supplémentaire située entre le support et la couche d'amorçage est adaptée à provoquer une adhérence plus faible de la couche d'amorçage avec le support qu'avec le substrat.

Selon un mode de réalisation, une première couche supplémentaire d'arrêt de gravure du support est située entre le support et la couche d'amorçage.

Selon un mode de réalisation, une deuxième couche supplémentaire d'adhérence de la couche d'amorçage est située entre la couche d'amorçage et la première couche supplémentaire.

Selon un mode de réalisation, la couche d'amorçage et le support sont séparés par un isolant électrique.

Selon un mode de réalisation, les parois de l'ouverture sont recouvertes d'une couche isolante.

Selon un mode de réalisation, ladite couche isolante est formée par oxydation thermique.

Selon un mode de réalisation, le procédé comprend une étape de formation de cavités borgnes dans une tranche comprenant le futur substrat, et une étape de retrait d'une partie de la tranche comprenant les fonds des cavités.

Selon un mode de réalisation, une portion de ladite couche isolante recouvrant lesdits fonds des cavités est laissée en place à l'étape de retrait, une autre couche isolante est déposée sur une autre face du substrat opposée à ladite face, et ladite portion est ensuite retirée.

Selon un mode de réalisation, une couche d'amorçage supplémentaire en contact avec ladite couche d'amorçage recouvre au moins une partie des parois des ouvertures.

Selon un mode de réalisation, le procédé comprend une étape de formation d'une autre couche d'amorçage sur ladite autre couche isolante ou sur une autre face du substrat opposée à ladite face.

Selon un mode de réalisation, l'étape d'électrodéposition comprend la formation d'une bille de soudage sur l'élément traversant.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en coupe schématique représentant un exemple de dispositif auquel s'appliquent les modes de réalisation décrits ;
la figure 2 est une vue en coupe schématique représentant un autre exemple de dispositif auquel s'appliquent les modes de réalisation décrits ;
la figure 3 est une vue en coupe schématique représentant une étape d'un mode de réalisation d'un procédé de fabrication d'un ou plusieurs éléments conducteurs traversant un substrat ;
la figure 4 est une vue en coupe schématique représentant une autre étape du procédé ;
la figure 5 est une vue en coupe schématique représentant une autre étape du procédé ;
la figure 6 est une vue en coupe, partielle et schématique, représentant un exemple de mode de réalisation d'un élément de la structure obtenue à l'étape de la figure 3 ;
la figure 7 est une vue en coupe schématique représentant une étape d'un premier mode de réalisation de l'étape de la figure 3 ;
la figure 8 est une vue en coupe schématique représentant une autre étape du premier mode de réalisation ;
la figure 9 est une vue en coupe schématique représentant une autre étape du premier mode de réalisation ;
la figure 10 est une vue en coupe schématique représentant une étape d'un deuxième mode de réalisation de l'étape de la figure 3 ;
la figure 11 est une vue en coupe schématique représentant une autre étape du deuxième mode de réalisation ;
la figure 12 est une vue en coupe schématique représentant une autre étape du deuxième mode de réalisation ;
la figure 13 est une vue en coupe schématique représentant une autre étape du deuxième mode de réalisation ;
la figure 14 est une vue en coupe schématique représentant une autre étape du deuxième mode de réalisation ;
la figure 15 est une vue en coupe schématique représentant un troisième mode de réalisation de l'étape de la figure 3 ;
la figure 16 est une vue en coupe schématique représentant une étape d'un quatrième mode de réalisation de l'étape de la figure 3 ;
la figure 17 est une vue en coupe schématique représentant une autre étape du quatrième mode de réalisation ;
la figure 18 est une vue en coupe schématique représentant une étape d'un cinquième mode de réalisation de l'étape de la figure 3 ;
la figure 19 est une vue en coupe schématique représentant une étape similaire à celle de la figure 4 après mise en oeuvre du cinquième mode de réalisation ; et
la figure 20 est une vue en coupe schématique représentant une variante de l'étape de la figure 5.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, des puces électroniques de circuit intégré et leurs circuits électroniques ne sont pas décrites en détail, les modes de réalisation décrits étant compatibles avec les puces usuelles de circuit intégré.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Dans la description qui suit, lorsque l'on fait référence à des qualificatifs de position absolue, tels que les termes "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

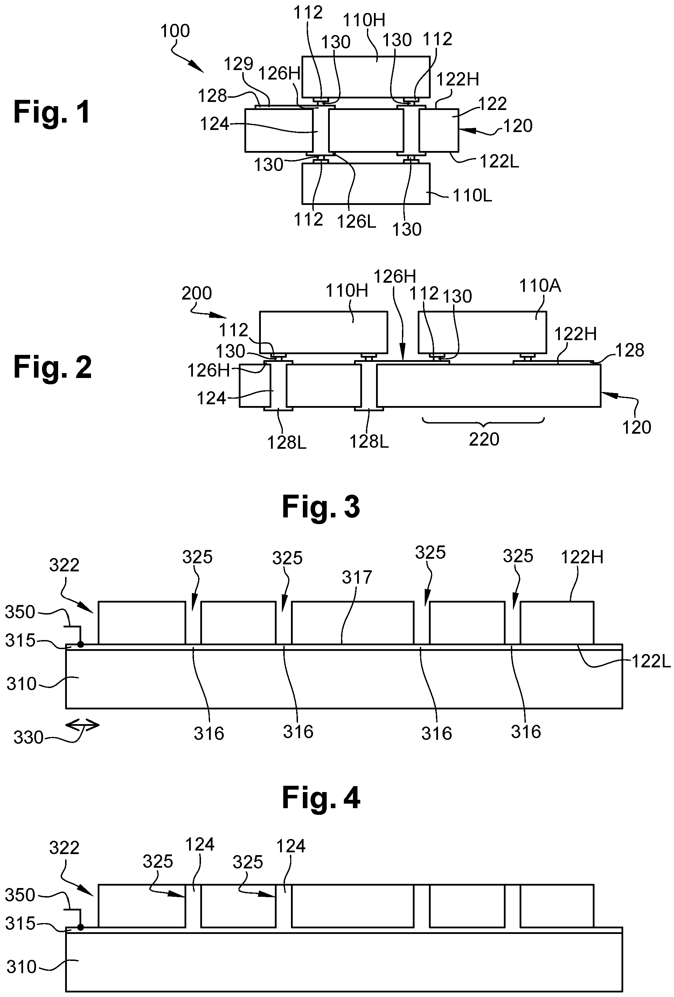

La figure 1 est une vue en coupe schématique représentant un exemple de dispositif 100 auquel s'appliquent les modes de réalisation décrits.

Le dispositif 100 comprend deux puces électroniques 110H et 110L situées sur deux faces opposées d'une structure de connexion 120. La structure de connexion 120 connecte entre eux des circuits des puces et assure le maintien mécanique des puces.

La structure de connexion 120 comprend un substrat 122. De préférence, le substrat 122 a une forme de plaque ou de tranche ayant deux faces opposées principales 122H et 122L. Le substrat 122 est préférentiellement une portion de tranche semiconductrice, par exemple en silicium. Le substrat 122 peut aussi être en céramique ou par exemple en verre, ou encore peut comprendre un matériau organique tel qu'une résine époxy, par exemple un mélange de résine époxy et fibres de verre. Plus généralement, le substrat peut être toute plaque, tranche ou portion de tranche dont les deux faces principales sont adaptées à être au moins en partie recouvertes d'éléments conducteurs.

Le substrat 122 est traversé par des vias 124. De préférence, les vias 124 connectent entre eux des régions électriquement conductrices 126L, 126H situés sur les faces opposées du substrat 122. Deux vias sont représentés à titre d'exemple, mais la structure de connexion 120 comprend de préférence un nombre de vias supérieur à 2. Chacun des vias 124 est défini par un élément conducteur traversant le substrat 122. Chaque via 124 connecte électriquement une région conductrice 126L située sur l'une des faces opposées (122L) du substrat, à une région conductrice 126H située sur l'autre des faces opposées (122H) du substrat. Les régions conductrices 126H et 126L sont typiquement des régions métalliques. Les vias 124 peuvent avoir des formes de cylindres, d'anneaux, d'anneaux concentriques, ou des formes remplissant des tranchées rectilignes (formes de murs). Les vias 124 ont typiquement des formes allongées dans la direction de l'épaisseur du substrat, c'est-à-dire que chaque via a une dimension plus grande dans la direction de l'épaisseur du substrat (direction longitudinale du via) que dans au moins une direction transverse du via.

Chaque puce 110H, 110L comprend des plots de connexion 112. Les plots de connexion 112 sont destinés à connecter des circuits électroniques (non représentés) de la puce à d'autres circuits extérieurs à la puce. De tels plots de connexion sont typiquement des régions métalliques situées sur la face avant ou sur la face arrière de la puce.

Les plots de connexion 112 des puces 110H et 110L sont connectés respectivement aux régions conductrices 126H et 126L. Plus précisément, chaque plot de connexion 112 est en contact électrique avec une des régions conductrices 126H et 126L, par exemple par l'intermédiaire d'un matériau de soudure ou de brasure 130 ou par collage direct métal-métal. Pour cela, les positions des régions conductrices 126H et 126L correspondent à celles des plots de connexion 112. En outre, le matériau 130 fixe mécaniquement les plots de connexion 112 sur les régions conductrices 126H et 126L, ce qui permet d'assurer le maintien mécanique des puces sur la structure de connexion 120. Dans l'exemple représenté, les plots de connexion 112 des puces 110H et 110L sont situés dans le prolongement des vias 124 (c'est-à-dire au-dessus et au-dessous des vias), cependant, les plots de connexion des puces sont souvent situés en dehors du prolongement des vias.

De préférence, les régions conductrices 126H et/ou 126L comprennent un ou des plots de connexion 128 et des pistes 129 reliant les plots de connexion 128 aux vias 124. On a représenté un seul plot de connexion 128, mais la structure de connexion comprend de préférence plusieurs plots de connexion 128 situés sur l'une et/ou l'autre des faces opposées 122H et 122L du substrat 122. Dans un exemple, le dispositif 100 est destiné à être disposé dans un boîtier muni de broches, et les plots de connexion 128 sont destinés à être connectés aux broches. Dans un autre exemple, les plots de connexion 128 sont destinés à connecter le dispositif 100 à un autre dispositif, non représenté.

Dans une variante, la structure de connexion 120 est constituée par une puce électronique. Le substrat est alors de préférence une portion de tranche semiconductrice, par exemple de silicium.

La figure 2 est une vue en coupe schématique représentant un autre exemple de dispositif 200 auquel s'appliquent les modes de réalisation décrits.

Le dispositif 200 de la figure 2 diffère du dispositif 100 de la figure 1 en ce que :
- la puce 110L est omise et les régions conductrices 126L sont remplacées par des plots de connexion 128L destinés à être connectés par exemple aux broches d'un boîtier ;
- une puce 110A est située sur une partie 220 dépourvue de vias de la structure de connexion 120, du côté de la face 122H ; et
- les régions conductrices 126H comprennent des pistes reliant les plots de connexion 112 de la puce 110A aux vias 124.

Les dispositifs 100 et 200 décrits ci-dessus en relation avec les figures 1 et 2 sont des exemples particuliers, et les modes de réalisation décrits ci-après s'appliquent à tout type de dispositif comprenant une ou plusieurs puces connectées à une structure de connexion 120 traversée par des vias. Plus généralement, les modes de réalisation décrits ci-après s'appliquent à tout dispositif comprenant un substrat tel que le substrat 122 traversé par des éléments conducteurs tels que les vias 124.

Les figures 3 à 5 sont des vues en coupe schématiques représentant des étapes d'un mode de réalisation d'un procédé de fabrication d'un ou plusieurs éléments conducteurs traversant un substrat 322.

Le substrat 322 peut être du type du substrat 122 décrit ci-dessus en relation avec les figures 1 et 2. Cependant, de préférence, le substrat 322 est une plaque, plus préférentiellement une tranche semiconductrice, destinée à être découpée en structures de connexion telles que les structures 120 des figures 1 et 2 et/ou en puces individuelles et/ou en tout substrat du type décrit en relation avec les figures 1 et 2.

Les éléments conducteurs que le procédé permet de former sont préférentiellement des vias du type des vias 124 des figures 1 et 2, ou constituent au moins une partie des vias 124. Plus précisément, les modes de réalisation décrits comprennent une étape de dépôt électrolytique, ou électrodéposition, d'au moins une partie des éléments conducteurs. Le matériau électrodéposé est préférentiellement du cuivre, bien que les modes de réalisation décrits s'appliquent aussi à tout matériau utilisé usuellement pour la réalisation de vias et pouvant être déposé électrolytiquement, tel que le nickel, les alliages de nickel et de fer, l'or, l'antimoine ou l'argent.

A l'étape de la figure 3, on forme un empilement comprenant successivement (de bas en haut) :
- un support 310, typiquement en forme de plaque ;
- une couche conductrice d'amorçage 315, parfois appelée couche de nucléation, c'est-à-dire une couche adaptée à former une cathode sur laquelle le matériau des éléments conducteurs peut être formé par électrodéposition ; et
- le substrat 322, traversé d'ouvertures 325 situées aux emplacements des futurs éléments conducteurs.

Le support 310 est de préférence de même nature que le substrat 322, ou le support 310 a un coefficient de dilation thermique identique ou sensiblement identique à celui du substrat 322. Ceci permet d'éviter divers problèmes de déformation de l'empilement au cours d'étapes ultérieures du procédé. De tels problèmes seraient susceptibles d'apparaître suite par exemple à une élévation de la température de l'empilement si le substrat et le support ne se dilatent pas de la même manière.

Les ouvertures 325 s'étendent préférentiellement orthogonalement aux faces principales 122H et 122L du substrat 322, autrement dit, les ouvertures ont un côté situé du côté de la face 122H et un autre côté situé du côté de la face 122L. Les ouvertures 325 sont formées aux emplacements des futurs éléments conducteurs tels que des vias. Les ouvertures 325 ont de préférence un facteur de forme supérieur à 10. Le facteur de forme d'un élément tel que les ouvertures 325 ou les vias est défini par le rapport entre la dimension de l'élément dans une direction longitudinale orthogonale aux faces principales du substrat et la plus petite dimension transversale de l'élément.

Dans l'empilement, le substrat 322 et les ouvertures 325 sont situés d'un même côté de la couche d'amorçage 315. Autrement dit, la couche d'amorçage 315 présente une face 317, tournée vers le substrat, adaptée à recevoir le matériau des éléments conducteurs. Plus précisément, pour chacune des ouvertures 325, une portion 316 de la couche d'amorçage ferme ou obture l'ouverture du côté de la face du substrat recouverte par la couche d'amorçage (face 122L).

De préférence, la couche 315 est une couche pleine, c'est-à-dire ne présentant pas d'ouvertures, plus préférentiellement uniforme, c'est-à-dire d'épaisseur constante. Chaque portion 316 obture alors entièrement l'ouverture 325 correspondante. La couche 315 permet, par rapport à une couche qui serait discontinue et/ou non uniforme, d'améliorer l'adhérence de la couche et le remplissage ultérieur des ouvertures 325 par le matériau électrodéposé.

De préférence, la couche d'amorçage 315 est de forme plane, c'est-à-dire que les portions 316 se situent dans le prolongement de la couche d'amorçage 315. Cependant, ceci n'est pas limitatif, et les portions 316 peuvent être situées à n'importe quelle position dans et/ou en vis-à-vis (ou à l'aplomb) de l'ouverture, du côté de l'ouverture tourné vers le support. La couche d'amorçage est par exemple en le même matériau que celui qui sera déposé. A titre d'exemple, la couche d'amorçage est une couche de cuivre d'épaisseur comprise entre 100 nm à 2 µm.

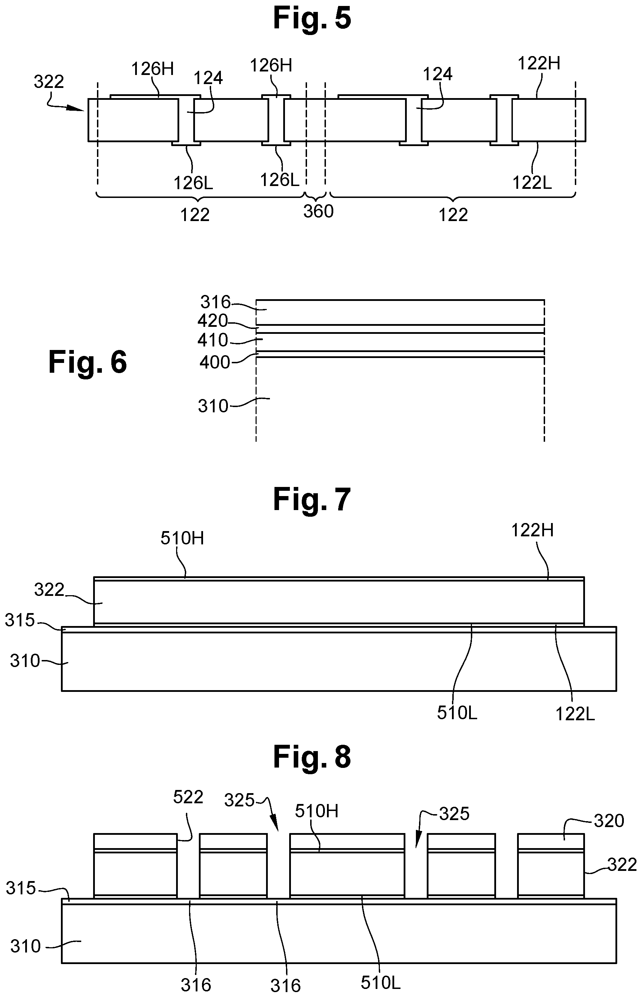

Les modes de réalisation décrits sont compatibles avec tout procédé de réalisation d'un empilement tel que celui de la figure 3. De préférence, le support 310 est préalablement recouvert de la couche d'amorçage 315. Les ouvertures 325 peuvent être formées avant ou après mise en place du substrat sur la couche d'amorçage 315 recouvrant le support 310. Divers exemples de modes de réalisation de l'empilement du support 310, de la couche d'amorçage 315, et du substrat 322 traversé des ouvertures 325, sont décrits ci-après en relation avec les figures 6 à 18.

En outre, bien que l'ensemble du substrat 322 et de la couche d'amorçage 315 soit situé sur un support, ceci n'est pas limitatif, et on pourrait omettre le support 310. Cependant, le fait de prévoir le support 310 préalablement recouvert de la couche d'amorçage 315 facilite (ou permet, dans le cas où le substrat est trop fin pour être manipulable) la mise en place et le maintien de la couche d'amorçage contre les ouvertures 325 et la face 122L du substrat, par rapport à un mode de réalisation dans lequel le support 310 serait omis.

De préférence, dans une partie périphérique de l'empilement, le support 310 et la couche d'amorçage 315 s'étendent latéralement au-delà du substrat 322. Autrement dit, une partie périphérique 330 de la couche d'amorçage 315 et du support 310 dépasse autour du substrat 322. La face tournée vers le substrat 322 de la couche d'amorçage 315 est ainsi accessible ou dégagée dans la partie périphérique 330, c'est-à-dire que cette face n'est pas recouverte par le substrat 322. A titre d'exemple, la partie périphérique 330 a une largeur d'environ 5 mm. De préférence, le substrat et le support sont deux plaques de formes circulaires ayant des diamètres différents. A titre d'exemple, le substrat et le support sont obtenus à partir de deux plaques circulaires identiques, par exemple des tranches semiconductrices telles que des tranches de silicium, et on a retiré une partie périphérique de la plaque destinée à former le substrat 322.

On forme une connexion électrique 350 en contact avec la couche d'amorçage 315 dans la partie périphérique 330. La connexion électrique 350 est prévue pour appliquer un potentiel de cathode à la couche d'amorçage pendant la mise en oeuvre de l'électrodéposition. Bien que la connexion électrique 350 soit située sur la partie périphérique 350, ceci n'est pas limitatif, les modes de réalisation décrits étant compatibles avec toute connexion électrique avec la couche d'amorçage 315. En particulier, la partie périphérique peut être omise. Cependant, le fait de prévoir la connexion électrique 350 dans la partie périphérique facilite la mise en place de la connexion électrique par rapport à un dispositif dépourvu de la partie périphérique 330. Le support, en particulier sa taille, est compatible avec les équipements usuels d'électrodéposition.

A l'étape de la figure 4, on dépose par électrodéposition dans les ouvertures 325 le matériau des éléments conducteurs à former. De préférence, on remplit les ouvertures en totalité, ce qui permet d'obtenir des vias 124 traversant le substrat 322. En variante, seule une partie des ouvertures est remplie par le matériau électrodéposé, et le reste de l'ouverture peut être rempli d'un autre matériau conducteur par tout procédé usuel.

L'électrodéposition est réalisée par le passage d'un courant circulant à partir d'une anode jusqu'à la couche d'amorçage 315 en passant par un électrolyte. L'anode et l'électrolyte ne sont ni détaillés ni représentés, et les paramètres de l'électrolyse ne sont pas décrits ici, les modes de réalisation décrits étant compatibles avec les procédés usuels d'électrodéposition. En particulier, les modes de réalisation décrits sont compatibles avec les techniques usuelles utilisées pour améliorer la diffusion des espèces chimiques dans l'électrolyte, telles que l'agitation, l'ajout d'agent accélérateur, etc.

Du fait que la couche d'amorçage recouvre au moins une partie de la face 122L, et que les portions 316 de la couche d'amorçage fermant les ouvertures 135 se situent du côté de la face 122L, le courant parvient exclusivement à la couche d'amorçage située au fond des ouvertures 325. Au début du dépôt, les ions métalliques situés dans l'électrolyte sont attirés par les portions 316 de la couche d'amorçage (portées au potentiel de cathode). Ainsi, le dépôt croit à partir du fond des ouvertures. Autrement dit, l'électrodéposition est effectuée à partir des portions 316 de la couche d'amorçage 315 obturant les ouvertures 325. En particulier, par rapport à un procédé qui utiliserait une couche d'amorçage recouvrant la face supérieure 122H, on évite le risque que le dépôt électrolytique se formant sur la face 122H bouche les ouvertures avant remplissage complet. On peut ainsi obtenir de manière simple des facteurs de forme de vias supérieurs à 10, par exemple supérieurs à 20. Dans un exemple, le substrat a une épaisseur (correspondant à une hauteur de vias) supérieure à 200 µm et les vias ont des largeurs inférieures à 10 µm. Dans un autre exemple, la hauteur des vias est comprise entre 100 à 400 µm et les vias ont des diamètres compris entre 0,5 à 10 µm.

Augmenter le facteur de forme des vias permet, pour une épaisseur donnée du substrat, d'augmenter le nombre de vias par unité de surface du substrat, ou, pour un nombre donné de vias par unité de surface, d'augmenter l'épaisseur du substrat. On peut ainsi augmenter le nombre de vias et/ou renforcer mécaniquement le substrat.

Selon un avantage, les vias obtenus sont borgnes, c'est-à-dire bouchent entièrement les ouvertures 325. De tels vias borgnes forment de meilleures connexions électrique (c'est-à-dire avec une résistance électrique plus faible) que des vias qui ne bouchent pas entièrement les ouvertures, par exemple des vias dont le matériau conducteur recouvre les parois des ouvertures mais laisse un passage au centre des ouvertures.

Selon un autre avantage, on peut se passer de couche d'amorçage sur les parois des ouvertures 135. On évite ainsi divers problèmes de dépôt de cette couche lorsque les ouvertures ont des facteurs de formes élevés, par exemple supérieurs à 10. En outre, les modes de réalisation décrits sont compatibles avec tout procédé, conforme ou non-conforme, de formation de la couche d'amorçage sur le support 310. A titre d'exemple, la couche d'amorçage est réalisée par dépôt chimique ou physique par phase vapeur CVD ou PVD (Physical Vapor Deposition), ou par dépôt physique par phase vapeur ionisée IPVD (Ionized Physical Vapor Déposition). La formation de la couche d'amorçage est donc plus simple que pour une couche d'amorçage recouvrant les parois intérieures des ouvertures 135.

A l'étape de la figure 5, on forme des régions conductrices 126H, telles que décrites en relation avec la figure 1, sur la face 122H du substrat 322. Les régions conductrices 126H sont préférentiellement formées sur une couche d'isolant, non représentée en figure 5, traversée par les vias 124. De préférence, sur chaque via 124, une des régions 126H recouvre l'extrémité du via et s'étend sur le substrat autour du via. Les modes de réalisations décrits sont compatibles avec les procédés usuels de formation de régions métalliques sur les faces d'un substrat.

On retire ensuite le substrat 310. De préférence, la couche d'amorçage 315 reste sur la face 122L du substrat 322. En variante, le substrat 310 est retiré avant formation des régions conductrices 126H.

On forme ensuite des régions conductrices 126L. A titre d'exemple, les régions conductrices 126L, telles que décrites en relation avec la figure 1, sont formées sur la face 122L. De préférence, les régions conductrices 126L sont des parties de la couche d'amorçage 315 et d'une éventuelle couche conductrice supplémentaire (non représentée) déposée sur la couche 315 après retrait du support 310. En variante, la couche supplémentaire est déposée sur le support 310 avant de former la couche d'amorçage 315. On retire, par exemple par gravure, une partie de la couche d'amorçage et de l'éventuelle couche supplémentaire, de sorte que les parties restantes constituent les régions conductrices 126L. De préférence, pour chacun des vias 124, une des régions 126L recouvre l'extrémité inférieure du via et s'étend sur la face 122L du substrat autour du via, et/ou une des régions 126H recouvre l'extrémité supérieure du via et s'étend sur la face 122H du substrat autour du via.

Outre le fait, mentionné précédemment en relation avec les figures 1 et 2, que les régions conductrices 126H et 126L permettent de former des pistes conductrices et des plots de connexion, les régions conductrices 126H et 126L s'étendant sur le substrat autour du via permettent d'améliorer la tenue mécanique du via en place dans l'ouverture 235 correspondante. Ainsi, les vias sont maintenus mécaniquement solidaires du substrat. En variante, les vias sont mécaniquement solidaires du substrat sans prévoir de régions 126H et 126L s'étendant sur le substrat autour de chaque via, par exemple par adhérence dans les ouvertures.

A titre d'exemple, à une étape ultérieure, on découpe le substrat 322 selon des chemins de découpe 360 afin de diviser le substrat 322 en substrats 122 individuels.

La figure 6 est une vue en coupe, partielle et schématique, représentant un exemple de mode de réalisation du support 310 recouvert de la couche d'amorçage 315, tel que décrit en relation avec la figure 3. Plus précisément, dans ce mode de réalisation, des couches supplémentaires 400, 410 et 420 sont intercalées, dans cet ordre à partir du support 310, entre le support 310 et la couche d'amorçage 315.

La couche supplémentaire 400 est électriquement isolante, par exemple la couche 400 est une couche d'oxyde de silicium. La couche supplémentaire 400 est préférentiellement en contact avec le support 310. Dans le cas d'un support électriquement conducteur ou semiconducteur, par exemple en silicium, la présence de cette couche facilite le dépôt électrolytique, en évitant que le support 310 soit porté au potentiel de cathode en même temps que la couche d'amorçage. Cependant, la couche 400 peut être omise, en particulier dans le cas où le support 310 est électriquement isolant.

La couche supplémentaire 410 est adaptée à provoquer une adhérence plus faible de la couche d'amorçage avec le support 310 qu'avec le substrat 322. La couche 410 permet de retirer le support à l'étape de la figure 5 en exerçant une force de séparation entre le support et le substrat, en sorte de rompre la couche 410 ou de la séparer de la couche 400 et/ou de la couche 420. Dans un mode de réalisation, la couche 410 est par exemple en un matériau polymère de type thermoplastique, c'est-à-dire une colle temporaire. L'épaisseur de la couche 410 est, de préférence, de quelques micromètres, par exemple comprise entre 5 µm et 10 µm. La couche 410 peut être en tout matériau, par exemple métallique, dont l'énergie d'adhésion avec la couche 400 est suffisamment faible pour pouvoir séparer les couches 400 et 410 en laissant la couche d'amorçage 315 sur le substrat 322. Ceci n'est pas limitatif, les modes de réalisation décrits sont compatibles avec tout mode de retrait du support 310. Ainsi, dans une variante, le support 310 est retiré par gravure, et la couche supplémentaire 410 est omise ou constitue une couche d'arrêt de gravure.

En variante, les couches supplémentaires 400 et 410 sont confondues, c'est-à-dire que la couche supplémentaire 410, adaptée à faciliter le retrait du support 310, constitue une couche d'isolation électrique.

La couche supplémentaire 420 est en un matériau adapté à faciliter la formation et/ou l'accroche de la couche d'amorçage sur la couche 410. La couche 420 est par exemple en titane ou en nitrure de titane. L'épaisseur de la couche 420 est par exemple comprise entre 50 et 200 nm. En variante, la couche supplémentaire 420 est omise.

Les figures 7 à 9 sont des vues en coupe schématiques représentant des étapes d'un premier mode de réalisation de l'étape de la figure 3. Plus précisément, dans ce mode de réalisation, les ouvertures 325 sont formées après mise en place du substrat 322 sur le support 310.

A l'étape de la figure 7, on met le substrat 322, par exemple une tranche de silicium, en place sur la couche d'amorçage 315 recouvrant le support 310. De préférence, la face 122L du substrat a été préalablement recouverte d'une couche électriquement isolante 510L, par exemple en oxyde de silicium. Pour cette mise en place, de préférence, on réalise préalablement un polissage, par exemple un polissage mécanochimique, de la face de la couche isolante 510L (ou du substrat 322 en l'absence de couche 510L) destinée à être en contact avec la couche d'amorçage, et/ou de la face de la couche d'amorçage destinée à être en contact avec la couche isolante 510L (ou avec le substrat 322, face 122L). De préférence, les états de surface des faces ainsi polies permettent une adhérence de type collage moléculaire entre la couche d'amorçage et la couche isolante 510. Le collage est typiquement obtenu par mise sous pression et chauffage.

De préférence, le collage obtenu est suffisant pour être étanche, en particulier vis-à-vis de l'électrolyte utilisé à l'étape de la figure 4, sur au moins 90 % de la surface collée. Ceci n'est pas limitatif, et le substrat 322 et la couche d'amorçage 315 peuvent, en variante, être assemblés de manière non étanche, par exemple le substrat peut être seulement posé sur le support. Cependant, par rapport à une telle variante, le collage étanche permet de faciliter les étapes, postérieures à l'électrodéposition, de retrait du support et de formation de régions conductrices sur la face 122L à partir de la couche d'amorçage 315.

De préférence, la face 122H du substrat est recouverte d'une couche isolante 510H. La couche isolante 510H est par exemple formée en même temps que la couche 510L, par exemple par oxydation thermique. En variante, la couche isolante est formée après l'étape de la figure 8. Dans cette variante, on peut prévoir d'amincir le substrat 322 avant l'étape de la figure 8.

A l'étape de la figure 8, on forme par lithographie un masque 520 traversé d'ouvertures 522 sur les emplacements des futures ouvertures 325. On grave ensuite les ouvertures 325 verticalement à l'aplomb des ouvertures 522, à partir de la surface supérieure de la couche 510H jusqu'au niveau de la face supérieure de la couche d'amorçage 315, ou jusqu'à un niveau situé dans la couche d'amorçage 315. Les ouvertures 325 traversent la couche isolante supérieure 510H, le substrat 322, et la couche isolante 510L. La couche d'amorçage 315 a des portions 316 dégagées, ou accessibles, situées au fond des ouvertures 325. Les modes de réalisation décrits sont compatibles avec les procédés usuels de gravure directionnelle de couches d'isolant et de substrat.

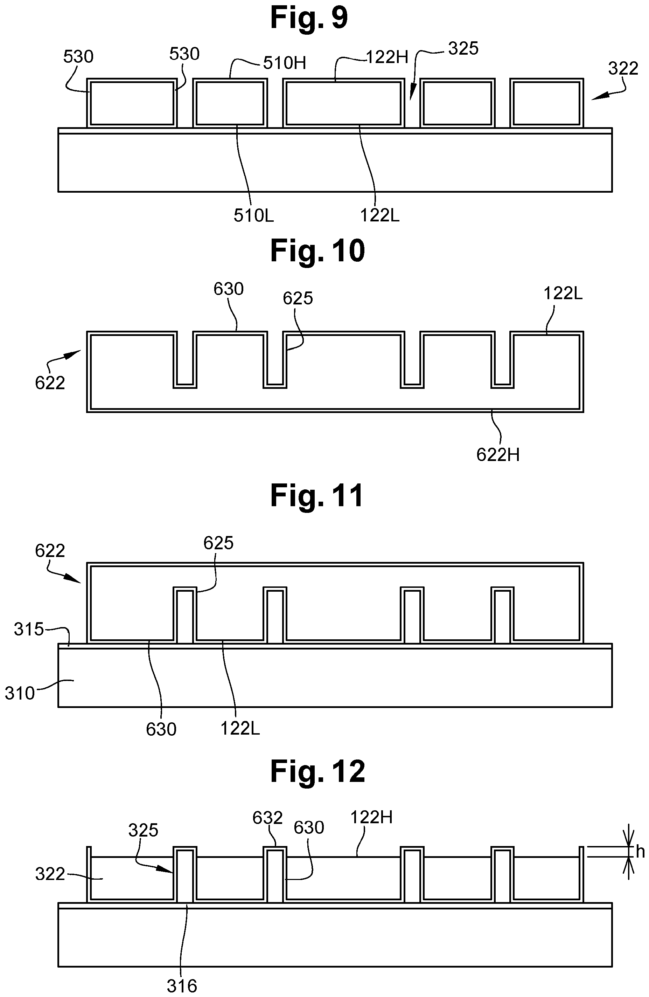

A l'étape de la figure 9, on retire le masque 520. On recouvre les parois des ouvertures 325 par une couche d'isolant électrique 530, par exemple de l'oxyde de silicium. La couche isolante 510H peut être, en totalité ou en partie, formée à cette étape.

La couche d'isolant 530 permet d'isoler électriquement entre eux le substrat et les futurs vias formés dans les ouvertures. En outre, la couche isolante permet d'éviter que le matériau des futurs vias diffuse vers le substrat et dégrade les propriétés du matériau du substrat. Les couches isolantes 510L et 510H permettent d'obtenir une isolation électrique entre le substrat et les futures régions conductrices 126L et 126H (figure 5) formées sur ses faces 122L et 122H.

Selon un mode de réalisation préféré, l'isolant électrique 530 est déposé de manière conforme, préférentiellement par un procédé de type CVD. Le budget thermique d'un tel dépôt permet de prévoir une couche supplémentaire en polymère, du type de la couche 410 (figure 6), située entre le support 310 et la couche d'amorçage 315. En outre, le budget thermique d'un tel dépôt est compatible avec le substrat 322 dans le cas où celui-ci est destiné à être découpé en puces individuelles, le substrat 322 comportant alors des éléments des circuits électroniques des puces. Les modes de réalisation ici décrits sont compatibles avec les procédés usuels de dépôt conforme de couche isolante.

Les figures 10 à 14 sont des vues en coupe schématiques représentant des étapes d'un deuxième mode de réalisation de l'étape de la figure 3. Plus précisément, les ouvertures 325 sont réalisées en partie avant et en partie après mise en place du substrat 322 sur le support 310.

A l'étape de la figure 10, on prévoit une tranche 622 dans laquelle le futur substrat 322 sera défini, par exemple une tranche semiconductrice telle qu'une tranche de silicium.

On forme ensuite, à partir d'une face de la tranche de silicium destinée à constituer la future face inférieure 122L du futur substrat (représenté retourné), des cavités borgnes 625, c'est-à-dire des cavités ne débouchant pas sur la face (face 622H) de la tranche 622 opposée à la face 122L.

De préférence, on retire une partie périphérique de la tranche 622 (correspondant à la partie 330 en figure 3). Le retrait peut être effectué avant ou après la formation des cavités 625.

Après cela, on forme une couche isolante 630 recouvrant toutes les surfaces de la tranche 622, ainsi que les parois et les fonds des cavités. De préférence, la couche isolante 630 est formée par oxydation thermique. L'oxydation thermique présente l'avantage, par rapport à un procédé de dépôt, de faciliter la formation de la couche isolante sur les parois de cavités ayant les facteurs de forme élevés définis ci-dessus, en particulier sur les parois de cavités ayant des facteurs de forme très élevés, par exemple supérieurs à 15.

A l'étape de la figure 11, on procède à la mise en place de la tranche 622 sur la couche d'amorçage 315 recouvrant le support 310. La partie de la couche 630 recouvrant la face 122L est mise en contact avec la couche d'amorçage. La mise en place est préférentiellement faite de manière similaire à celle décrite en relation avec la figure 7. En particulier, on procède de préférence à un collage de type moléculaire après avoir effectué un polissage des surfaces à coller ensemble. A titre d'exemple, la distance entre le fond des cavités 625 et la face 622H est comprise entre 5 et 50 µm, de préférence entre 10 et 20 µm. Cette distance est, dans l'exemple représenté, obtenue à l'étape de la figure 10, cependant, cette distance est préférentiellement obtenue par une étape, non représentée, d'amincissement de la tranche 622 du côté de sa face 622H.

A l'étape de la figure 12, on retire, de préférence d'abord par polissage mécanique, puis par gravure, une partie de la tranche comprenant les fonds des cavités. La partie restante de la tranche constitue le substrat 322. Chacune des cavités 635 devient une ouverture 325 traversant le substrat.

De préférence, le retrait du matériau de la tranche est sélectif par rapport au matériau de la couche isolante 630. Ainsi, une portion de couche isolante 630 recouvrant initialement les fonds des cavités 625 est laissée en place à l'étape de retrait. De préférence, le retrait est effectué de sorte que des portions 632 de la couche 630 initialement situées au fond des cavités 625 se retrouvent au-dessus de la surface supérieure du substrat (face 122H). Le niveau de la face 122H est de préférence situé à une hauteur h de quelques micromètres, par exemple entre 2 µm et 10 µm, sous le niveau inférieur des portions 632 (c'est-à-dire le niveau des faces des portions 632 orientées vers les ouvertures 325).

En variante, on retire également les portions 632 de la couche 630, et on obtient la structure permettant l'électrolyse de l'étape de la figure 4. Ce retrait est effectué par exemple par polissage mécanochimique ou par gravure sèche, afin de ne pas endommager les portions de la couche 630 recouvrant les parois des ouvertures 325 et/ou les portions 316 de la couche d'amorçage situées sous les ouvertures 325.

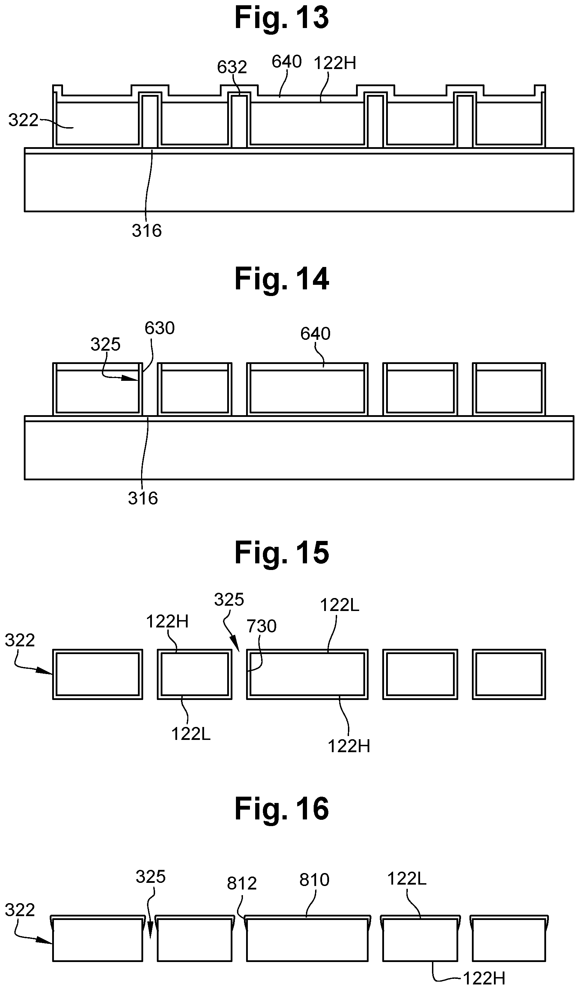

A l'étape de la figure 13, on dépose sur la face supérieure 122H du substrat une autre couche isolante (couche 640), par exemple en oxyde de silicium. Les portions de la couche 632 permettent d'éviter qu'une partie du matériau de la couche 640 soit déposée dans les ouvertures 325. De préférence, l'épaisseur de la couche 640 est inférieure à la hauteur h entre la face 122H et le niveau inférieur des portions 632.

A l'étape de la figure 14, on retire tous les éléments situés au-dessus du niveau supérieur de la couche 640, de préférence par polissage. Ceci retire les portions 632 de la couche d'isolant 630. Les portions de la couche 640 situées sur la portion 632 sont également retirées. La différence de niveau h permet ainsi de déboucher les ouvertures 325 par le polissage, en évitant d'endommager les portions de la couche 630 recouvrant les parois des ouvertures 325 et/ou les portions 316 de la couche d'amorçage situées sous les ouvertures 325.

La structure obtenue à l'étape de la figure 14 peut être utilisée pour réaliser l'électrolyse décrite en relation avec la figure 4. Les portions de la couche 630 situées sur les parois des ouvertures permettent d'isoler électriquement les vias ou les éléments conducteurs formés dans les ouvertures, et permettent en outre d'éviter la diffusion vers le substrat 322 du matériau électrodéposé dans les ouvertures 325.

La couche 640 obtenue permettra, dans la structure obtenue à l'étape de la figure 5, d'obtenir une isolation électrique entre les régions conductrices 126H (figure 5) et le substrat 322.

La figure 15 est une vue en coupe schématique représentant un troisième mode de réalisation de l'étape de la figure 3. Plus particulièrement, les ouvertures 325 sont formées avant la mise en place du substrat 322 sur la couche d'amorçage 315 recouvrant le support 310 (support et couche d'amorçage non représentés en figure 15).

A l'étape de la figure 15, on forme les ouvertures 325 dans le substrat 322. Le substrat est de préférence défini par une portion de tranche semiconductrice, par exemple en silicium. Ce mode de réalisation est compatible avec tout moyen usuel de former des ouvertures dans un substrat, tel qu'une gravure chimique ou par plasma, un usinage laser, un usinage mécanique, un usinage par eau pressurisée, etc.

On forme ensuite une couche isolante 730 recouvrant toutes les surfaces du substrat 322, et en particulier les parois des ouvertures 325. La couche isolante 730 est préférentiellement obtenue par oxydation thermique, par exemple à une température de l'ordre de 1000°C. Comme ceci a été mentionné, l'oxydation thermique permet de former la couche isolante sur les parois d'ouvertures ayant des facteurs de forme élevés plus facilement que des procédés de dépôt conforme.

Dans une variante, une couche isolante est formée sur la face supérieure 122H et/ou une couche isolante est formée sur la face inférieure 122L préalablement à la formation des ouvertures 325. Cette ou ces couches isolantes sont alors traversées par les ouvertures. La présence de cette couche permet de limiter la croissance de l'oxyde sur les faces 122H et 122L au cours de l'oxydation thermique.

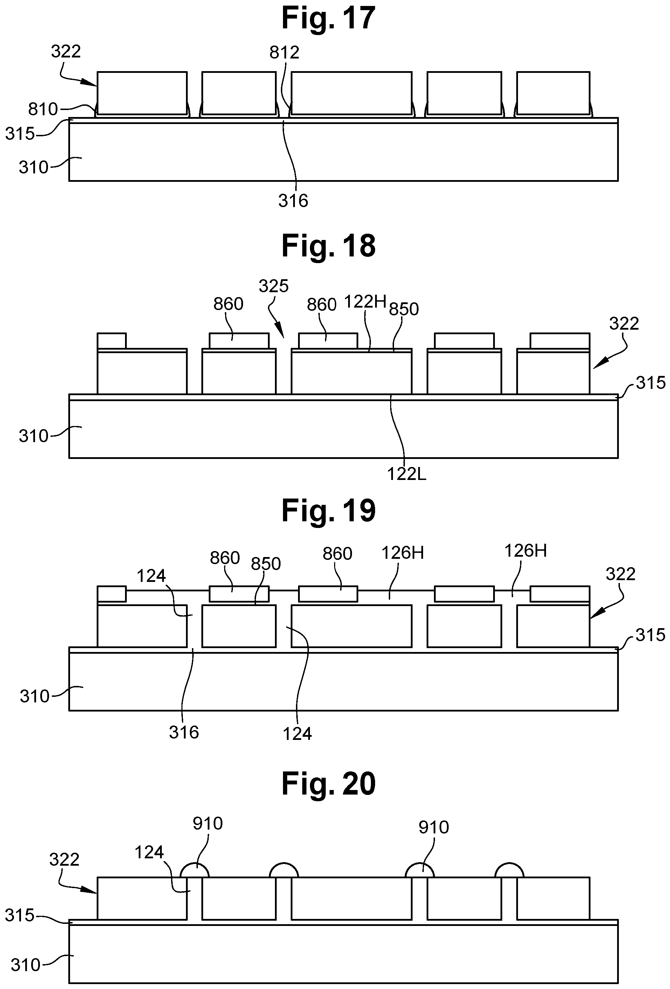

Les figures 16 et 17 sont des vues en coupe schématiques représentant des étapes d'un quatrième mode de réalisation de l'étape de la figure 3.

A l'étape de la figure 16, on forme les ouvertures 325 traversant le substrat 322. On forme ensuite une couche conductrice 810 sur la face 122L du substrat (face destinée à être recouverte par la couche d'amorçage 135). La couche conductrice 810 est déposée de sorte qu'une partie 812 de la couche 810 recouvre une partie des parois des ouvertures 325 du côté de la face 122L. Ceci peut être obtenu par un dépôt incomplètement conforme, dans lequel le matériau déposé ne parvient pas dans les parties des ouvertures 325 les plus éloignées de la face 122L, en particulier du fait d'un facteur de forme élevé des ouvertures 325.

A l'étape de la figure 17, on met le substrat en place sur le support 310. Plus précisément, on met la couche 810 et la couche d'amorçage 315 en contact l'une avec l'autre, de préférence par collage de type moléculaire.

De préférence, la couche 810 est du même matériau que la couche d'amorçage, ou en un autre matériau sur lequel le dépôt électrolytique peut être formé. La couche métallique 810 constitue ainsi une couche d'amorçage supplémentaire. Les portions 812 de la couche d'amorçage 810 sont en contact avec les portions 316 de la couche d'amorçage 315 et permettent de faciliter le démarrage du dépôt électrolytique par rapport à une électrodéposition réalisée sans les portions 812.

De préférence, la couche 810 est formée sur une couche d'accrochage, non représentée, par exemple en titane ou en nitrure de titane. La couche d'accrochage permet une meilleure adhésion du métal, par exemple du cuivre, de la couche 810. Ceci permet d'assurer la solidarité mécanique entre le futur via et le substrat 322. En outre, la couche d'accrochage peut avoir des propriétés de barrière permettant d'éviter la diffusion du matériau électrodéposé vers le substrat, et permet donc d'éviter que le matériau du substrat soit altéré par cette diffusion.

Ce mode de réalisation est combinable avec les modes de réalisation dans lesquelles les ouvertures ou cavités sont formées, ou partiellement formées, avant mise en place du substrat sur le support, par exemple le mode de réalisation des figures 10 à 14 ou celui de la figure 15.

En variante, la couche 810 couvre entièrement les parois des ouvertures 325.

La figure 18 est une vue en coupe schématique représentant une étape d'un cinquième mode de réalisation de l'étape de la figure 3. La figure 19 est une vue en coupe schématique représentant une étape similaire à celle de la figure 4 après mise en oeuvre du cinquième mode de réalisation.

A l'étape de la figure 18, on forme une autre couche d'amorçage (couche 850) sur la face supérieure 122H du substrat. De préférence, la couche d'amorçage 850 est formée après formation des ouvertures 325. La couche d'amorçage 850 peut alors, selon la conformité du dépôt, recouvrir le substrat 322 seulement autour des ouvertures ou recouvrir aussi au moins une partie des parois des ouvertures. On forme ensuite des portions isolantes 860 sur la couche 850. Les portions isolantes 860 sont de préférence formées aux emplacements de la face 122H qui seront, après mise en oeuvre de l'étape de la figure 5, dépourvues de régions conductrices 126H. A titre d'exemple, on forme une couche en résine photosensible, par exemple une résine en film sec DFR (Dry Film Resist) afin que la résine ne pénètre pas dans les cavités 325. On retire ensuite, par lithographie, les portions de la résine aux emplacements des futures régions conductrices 126H. Les portions restantes de la couche de résine constituent les portions isolantes 860.

A l'étape de la figure 19, les vias 124 sont formés par électrodéposition. A la fin de la formation des vias 124, ceux-ci forment un contact électrique avec la couche d'amorçage 850, et le dépôt se poursuit sur toutes les portions de couche d'amorçage non recouvertes par les portions 860. Les portions ainsi déposées formeront les régions conductrices 126H après retrait, à l'étape de la figure 5, des parties de la couche d'amorçage 850 situées sous les portions 860.

Tant que les vias en formation n'ont pas rejoint la couche d'amorçage 850, le dépôt se forme seulement à partir des potions 316 de la couche d'amorçage 310 (à partir du fond des ouvertures). On peut réaliser ainsi les vias 124 et les régions conductrices 126H au cours d'une même étape d'électrolyse, ce qui simplifie le procédé de fabrication, tout en bénéficiant des avantages susmentionnés, en particulier l'avantage de réaliser des vias ayant des facteurs de forme élevés sans risque de boucher les parties supérieures des cavités avant d'avoir formé complètement les vias.

Dans une variante de réalisation, on omet les portions 860. L'électrodéposition est alors réalisée sur toute la surface de la couche 850. A l'étape de la figure 5, on grave ensuite les parties de la couche 850 situées en dehors des régions conductrices 126H.

Le présent mode de réalisation est compatible avec les modes de réalisation précédents, à savoir que le substrat 322 peut correspondre au substrat obtenu dans les modes de réalisation des figures 7 à 9, des figures 10 à 14, de la figure 15, et/ou des figures 16 et 17. En particulier, la couche d'amorçage 850 peut être formée sur une couche isolante telle que la couche 510H (figure 9), 640 (figure 14) ou 730 (figure 15).

La figure 20 est une vue en coupe schématique représentant une variante de l'étape de la figure 5. Dans cette variante, on forme, par électrodéposition, un plot de soudure 910 sur chacun des vias 124. Pour cela, on poursuit l'électrodéposition du matériau des vias par l'électrodéposition, préférentiellement d'un alliage fusible, par exemple un alliage à base d'étain. L'alliage est alors déposé uniquement sur les sommets des vias 124. Cette étape peut être suivie d'une étape de fusion permettant de donner aux plots de connexion 910 la forme de billes. Ce mode de réalisation est compatible avec ceux des figures 7 à 9, 10 à 14, 15, et/ou 16 et 17.

Enfin, la mise en oeuvre pratique des modes de réalisation et variantes décrits est à la portée de l'homme du métier à partir des indications fonctionnelles données ci-dessus.

## Revendications

1. Procédé de fabrication d'au moins un élément (124) traversant un substrat (322) assemblé sur un support (310), comprenant une étape d'électrodéposition d'au moins une partie dudit élément dans une ouverture (325) traversant le substrat (322) et sur une portion (316) d'une couche conductrice d'amorçage (315) située entre le substrat (322) et le support (310) sur au moins une partie d'une face (122L) du substrat, ladite portion (316) de couche d'amorçage étant située d'un même côté de l'ouverture (325) que ladite face (122L) du substrat, et le support (310) et la couche d'amorçage (315) s'étendant latéralement au-delà du substrat (322).

2. Procédé selon la revendication 1, dans lequel les ouvertures (325) ont un facteur de forme supérieur à 10.

3. Procédé selon la revendication 1 ou 2, dans lequel une première couche supplémentaire (410) située entre le support (310) et la couche d'amorçage (315) est adaptée à provoquer une adhérence plus faible de la couche d'amorçage (315) avec le support (310) qu'avec le substrat (322).

4. Procédé selon l'une quelconque des revendications 1 à 3, dans lequel une première couche supplémentaire (410) d'arrêt de gravure du support (310) est située entre le support et la couche d'amorçage (315).

5. Procédé selon la revendication 3 ou 4, dans lequel une deuxième couche supplémentaire (420) d'adhérence de la couche d'amorçage (315) est située entre la couche d'amorçage (315) et la première couche supplémentaire (410).

6. Procédé selon l'une quelconque des revendications 3 à 5, dans lequel la couche d'amorçage (315) et le support (310) sont séparés par un isolant électrique (400).

7. Procédé selon l'une quelconque des revendications 1 à 6, dans lequel les parois de l'ouverture (325) sont recouvertes d'une couche isolante (530 ; 630 ; 730).

8. Procédé selon la revendication 7, dans lequel ladite couche isolante (530 ; 630 ; 730) est formée par oxydation thermique.

9. Procédé selon la revendication 6 ou 7, comprenant une étape de formation de cavités borgnes (625) dans une tranche (622) comprenant le futur substrat (322), et une étape de retrait d'une partie de la tranche comprenant les fonds des cavités.

10. Procédé selon la revendication 9, dans lequel une portion (632) de ladite couche isolante (630) recouvrant lesdits fonds des cavités (622) est laissée en place à l'étape de retrait, une autre couche isolante (640) est déposée sur une autre face (122H) du substrat (322) opposée à ladite face (122L), et ladite portion (632) est ensuite retirée.

11. Procédé selon l'une quelconque des revendications 1 à 10, dans lequel une couche d'amorçage supplémentaire (810) en contact avec ladite couche d'amorçage (315) recouvre au moins une partie des parois des ouvertures (325).

12. Procédé selon l'une quelconque des revendications 1 à 11, comprenant une étape de formation d'une autre couche d'amorçage (850) sur ladite autre couche isolante (640) ou sur une autre face (122H) du substrat (322) opposée à ladite face (122L).

13. Procédé selon l'une quelconque des revendications 1 à 12, dans laquelle l'étape d'électrodéposition comprend la formation d'une bille de soudage (910) sur l'élément traversant (124).

## Patentansprüche

1. Verfahren zur Herstellung mindestens eines Elements (124), das ein auf einem Träger (310) montiertes Substrat (322) durchquert, aufweisend einen Schritt der galvanischen Abscheidung mindestens eines Teils des Elements in einer das Substrat (322) durchquerenden Öffnung (325) und auf einem Teil (316) einer leitenden Keimschicht (315), die sich zwischen dem Substrat (322) und dem Träger (310) auf mindestens einem Teil einer Oberfläche (122L) des Substrats befindet, wobei sich der Teil (316) der Keimschicht auf derselben Seite der Öffnung (325) wie die Oberfläche (122L) des Substrats befindet, und wobei sich der Träger (310) und die Keimschicht (315) seitlich über das Substrat (322) hinaus erstrecken.

2. Verfahren nach Anspruch 1, wobei die Öffnungen (325) einen Formfaktor von größer als 10 aufweisen.

3. Verfahren nach Anspruch 1 oder 2, wobei eine erste zusätzliche Schicht (410), die sich zwischen dem Träger (310) und der Keimschicht (315) befindet, eine geringere Haftung der Keimschicht (315) am Träger (310) als am Substrat (322) bewirken kann.

4. Verfahren nach einem der Ansprüche 1 bis 3, wobei eine erste zusätzliche Ätzstoppschicht (410) des Trägers (310) zwischen dem Träger und der Keimschicht (315) angeordnet ist.

5. Verfahren nach Anspruch 3 oder 4, wobei eine zweite zusätzliche Verbindungsschicht (420) der Keimschicht (315) zwischen der Keimschicht (315) und der ersten zusätzlichen Schicht (410) angeordnet ist.

6. Verfahren nach einem der Ansprüche 3 bis 5, wobei die Keimschicht (315) und der Träger (310) durch einen elektrischen Isolator (400) getrennt sind.

7. Verfahren nach einem der Ansprüche 1 bis 6, wobei die Wände der Öffnung (325) mit einer Isolierschicht (530; 630; 730) bedeckt sind.

8. Verfahren nach Anspruch 7, wobei die Isolierschicht (530; 630; 730) durch thermische Oxidation gebildet wird.

9. Verfahren nach Anspruch 6 oder 7, aufweisend einen Schritt des Ausbildens von Blind-Hohlräumen (625) in einem Wafer (622), der das zukünftige Substrat (322) aufweist, und einen Schritt des Entfernens eines Teils des Wafers, der die Böden der Hohlräume aufweist.

10. Verfahren nach Anspruch 9, wobei ein Teil (632) der Isolierschicht (630), die die Böden der Hohlräume (622) bedeckt, beim Entfernungsschritt an Ort und Stelle belassen wird, eine weitere Isolierschicht (640) auf einer weiteren Oberfläche (122H) des Substrats (322) entgegengesetzt zur Oberfläche (122L) abgeschieden wird, und der Teil (632) dann entfernt wird.

11. Verfahren nach einem der Ansprüche 1 bis 10, wobei eine zusätzliche Keimschicht (810) in Kontakt mit der Keimschicht (315) wenigstens einen Teil der Wände der Öffnungen (325) bedeckt.

12. Das Verfahren gemäß einem der Ansprüche 1 bis 11, aufweisend einen Schritt des Ausbildens einer weiteren Keimschicht (850) auf der weiteren Isolierschicht (640) oder auf einer anderen Oberfläche (122H) des Substrats (322) entgegengesetzt zur Oberfläche (122L).

13. Verfahren nach einem der Ansprüche 1 bis 12, wobei der Schritt der galvanischen Abscheidung die Bildung einer Löterhebung (910) auf dem durchquerenden Element (124) aufweist.

## Claims

1. A method of manufacturing at least one element (124) crossing a substrate (322) assembled on a support (310), comprising a step of electrodeposition of at least a portion of said element in an opening (325) crossing the substrate (322) and on a portion (316) of a conductive seed layer (315) located between the substrate (322) and the support (310) on at least a portion of a surface (122L) of the substrate, said portion (316) of the seed layer being located on a same side of the opening (325) as said surface (122L) of the substrate, and the support (310) and the seed layer (315) extending laterally beyond the substrate (322).

2. The method according to claim 1, wherein the openings (325) have a form factor greater than 10.

3. The method according to claim 1 or 2, wherein a first additional layer (410) located between the support (310) and the seed layer (315) is capable of causing a lower adhesion of the seed layer (315) to the support (310) than to the substrate (322).

4. The method according to any of claims 1 to 3, wherein a first additional etch stop layer (410) of the support (310) is located between the support and the seed layer (315).

5. The method according to claim 3 or 4, wherein a second additional bonding layer (420) of the seed layer (315) is located between the seed later (315) and the first additional layer (410).

6. The method according to any of claims 3 to 5, wherein the seed layer (315) and the support (310) are separated by an electric insulator (400).

7. The method according to any of claims 1 to 6, wherein the walls of the opening (325) are covered with an insulating layer (530; 630; 730).

8. The method according to claim 7, wherein said insulating layer (530; 630; 730) is formed by thermal oxidation.

9. The method according to claim 6 or 7, comprising a step of forming of blind cavities (625) in a wafer (622) comprising the future substrate (322), and a step of removal of a portion of the wafer comprising the bottoms of the cavities.

10. The method according to claim 9, wherein a portion (632) of said insulating layer (630) covering said bottoms of the cavities (622) is left in place at the removal step, another insulating layer (640) is deposited on another surface (122H) of the substrate (322) opposite to said surface (122L), and said portion (632) is then removed.

11. The method according to any of claims 1 to 10, wherein an additional seed layer (810) in contact with said seed layer (315) covers at least a portion of the walls of the openings (325) .

12. The method according to any of claims 1 to 11, comprising a step of forming another seed layer (850) on said other insulating layer (640) or on another surface (122H) of the substrate (322) opposite to said surface (122L).

13. The method according to any of claims 1 to 12, wherein the electrodeposition step comprises the forming of a solder bump (910) on the crossing element (124).
